# EUROPEAN PATENT APPLICATION

(11) **EP 1 923 916 A2**
(43) Date of publication of application: **21.05.2008**
(21) Application number: 07120552.0
(22) Date of filing: 13.11.2007
(51) Int. Cl.: H01L 23/495

(54) **Semiconductor device**

(30) Priority: 20.11.2006 JP 2006313011
(71) Applicant: Rohm Co., Ltd., Kyoto-shi, Kyoto 615-8585 (JP)
(72) Inventor: Matsuoka, Yasufumi, Kyoto-shi, Kyoto 615-8585 (JP)
(74) Representative: Moser & Götze

(57) **Abstract**

A semiconductor device includes a resin package, a lower pad embedded in the package, an upper pad embedded in the package at a distance from the lower pad, a lower semiconductor element bonded to the lower pad, and an upper semiconductor element bonded to the upper pad and facing the lower semiconductor element. The lower surface of the lower pad is exposed at the bottom surface of the package, while the upper surface of the upper pad is exposed at the top surface of the package.

## Description

### BACKGROUND OF THE INVENTION

### 1. Field of the Invention:

The present invention relates to a semiconductor device provided with a plurality of semiconductor elements.

### 2. Description of the Related Art:

Recently, there has been an increasing demand for a composite semiconductor device incorporating a plurality of semiconductor elements. Such a composite semiconductor device is, as shown in JP-A-2005-136332 for example, manufactured by bonding two semiconductor elements side by side on the same lead member.

Fig. 11 is a plan view illustrating a composite semiconductor device X provided with two semiconductor elements 941, 942 bonded in a conventional manner. The semiconductor device X includes a main lead 910 (including a die bonding pad 911 and terminals 912), semiconductor elements 941, 942 mounted on the die bonding pad 911, and a group of terminals 930 electrically connected to the semiconductor elements 941, 942 via wires 950. As indicated by phantom lines, the semiconductor device X also includes a resin package 960 for protecting the semiconductor elements 941, 942 and the wires 950. The semiconductor device X is connected to an external circuit via the terminals 912 and the terminals 930.

In the conventional semiconductor device X, the main lead 910 is elongated in one direction (vertical direction in Fig. 11) so that the die bonding pad 911 can carry two semiconductor elements 941, 942. Disadvantageously, this configuration makes the outer dimension of the semiconductor device X as large as that of two non-composite semiconductor devices placed side by side.

### SUMMARY OF THE INVENTION

The present invention has been proposed under above-described circumstances. It is therefore an object of the present invention is to provide a semiconductor device capable of increasing the number of semiconductor elements mounted within a predetermined area.

According to the present invention, there is provided a semiconductor device comprising: a resin package including a first surface and a second surface opposite to the first surface; a first supporting conductor adjacent to the first surface and embedded in the resin package; a second supporting conductor adjacent to the second surface and embedded in the resin package, the second supporting conductor being spaced apart from the first supporting conductor by a predetermined distance; a first semiconductor element covered by the resin package and bonded to the first supporting conductor; and a second semiconductor element covered by the resin package and bonded to the second supporting conductor, the second semiconductor element facing the first semiconductor element. At least part of the first supporting conductor is exposed at the first surface of the resin package, and at least part of the second supporting conductor is exposed at the second surface of the resin package. Preferably, at least part of the first semiconductor element and at least part of the second semiconductor element may be located between the first supporting conductor and the second supporting conductor.

Preferably, the distance between the first and the second supporting conductors may be greater than the sum of the thickness of the first semiconductor element and the thickness of the second semiconductor element.

Preferably, the first supporting conductor may comprise a plurality of die bonding pads, and the first semiconductor element is mounted on one of the plurality of die bonding pads.

Preferably, the second supporting conductor may comprise a plurality of die bonding pads, and the second semiconductor element is mounted on one of the plurality of die bonding pads.

Preferably, the first supporting conductor may comprise a plurality of first die bonding pads, and the second supporting conductor may comprise a plurality of second die bonding pads. In addition, the first semiconductor element may be mounted on one of the plurality of first die bonding pads, while the second semiconductor element may be mounted on one of the plurality of second die bonding pads.

Preferably, the semiconductor device of the present invention may further comprise a plurality of first leads connected to the first semiconductor element and a plurality of second leads connected to the second semiconductor element. The plurality of first leads and the plurality of second leads may protrude from the resin package in opposite directions, for instance, the first leads to the right, and the second leads to the left.

Preferably, the semiconductor device of the present invention may further comprise a plurality of first wires and a plurality of second wires, wherein the plurality of first wires connect the plurality of first leads to the first semiconductor element, while the plurality of second wires connect the plurality of second leads to the second semiconductor element. The plurality of first wires are out of contact with the plurality of second wires. Other features and advantages will be apparent from the following description of the embodiments with reference to the accompanying drawings.

### BRIEF DESCRIPTION OF THE DRAWINGS

Fig. 1 is a plan view showing a semiconductor device according to a first embodiment of the present invention.
Fig. 2 is a sectional view taken along lines II-II in Fig. 1.
Fig. 3 is a sectional view taken along lines III-III in Fig. 1.
Fig. 4 is a sectional view taken along lines IV-IV in Fig. 3.
Fig. 5 is a plan view showing a semiconductor device according to a second embodiment of the present invention.
Fig. 6 is a bottom view showing the semiconductor device of the second embodiment.
Fig. 7 is a sectional view taken along lines VII-VII in Fig. 5.
Fig. 8 is a bottom view showing a semiconductor device according to a third embodiment of the present invention.
Fig. 9 is a sectional view showing the semiconductor device of the third embodiment, the section corresponding to that shown in Fig. 7.
Fig. 10 is a sectional view showing a semiconductor device according to a fourth embodiment of the present invention, the section corresponding to that shown in Fig. 7.
Fig. 11 is a plan view illustrating the main features of a conventional semiconductor device.

### DETAILED DESCRIPTION OF THE PREFERRED EMBODIMENTS

Preferred embodiments of the present invention will be described below with reference to the accompanying drawings.

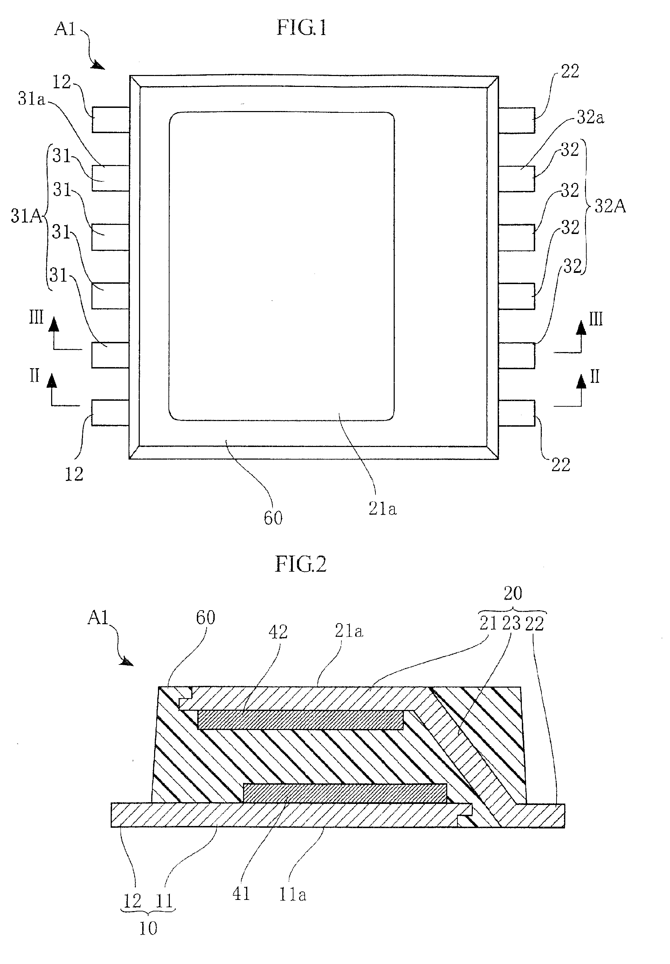

Figs. 1-4 show a semiconductor device according to a first embodiment of the present invention. The illustrated semiconductor device A1 includes a first main lead 10, a second main lead 20, a first lead group 31 A, a second lead group 32A, a first semiconductor element 41, a second semiconductor element 42, first wires 51, second wires 52, and a resin package 60.

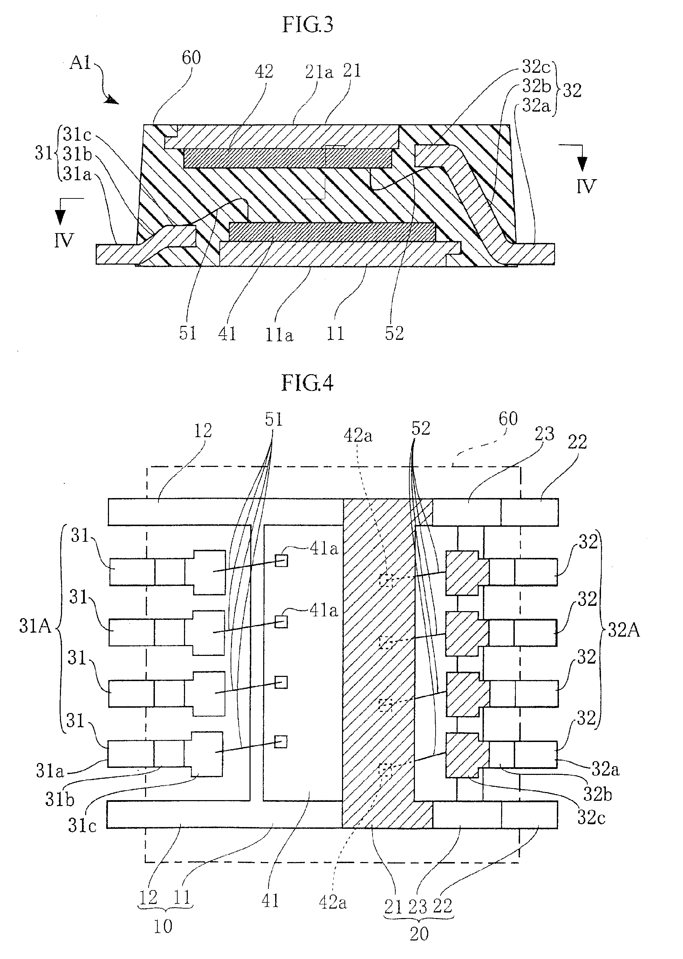

As shown in Figs. 2 and 4, the first main lead 10 includes a die bonding pad 11 ("first supporting conductor") on which the first semiconductor element 41 is mounted, and two strip-shaped terminals 12 protruding in the same direction from an edge of the die bonding pad 11. The first main lead 10 is positioned adjacent to the bottom surface of the resin package 60 in a manner such that the lower or reverse surface 11 a of the die bonding pad 11 is exposed to the outside at the bottom surface of the resin package 60.

As shown in Figs. 2 and 4, the second main lead 20 includes a die bonding pad 21 ("second supporting conductor") on which the semiconductor element 42 is mounted, two inclined portions 23 extending from an edge of the die bonding pad 21, and terminals 22 formed at the outer ends of the respective inclined portions 23. The die bonding pad 21 is located above and spaced apart from the die bonding pad 11 by an appropriate distance so that the first and second semiconductor elements 41, 42 carried thereon are arranged to parallely face each other, but not in contact with each other. To hold the two semiconductor elements 41, 42 out of contact, the distance between the upper pad 21 and the lower pad 11 is set to be greater than the sum of the thicknesses of the respective semiconductor elements 41, 42. As shown in Fig. 3, at least part of the first semiconductor element 41 and at least part of the second semiconductor element 42 are located between the upper and the lower die bonding pads 21, 11.

The die bonding pad 21 is positioned adjacent to the top surface of the resin package 60, and its upper or obverse surface 21 a is exposed to the outside at the top surface of the resin package 60. The terminals 22 are positioned adjacent to the bottom surface of the resin package 60, protruding sideways from an side surface of the resin package 60 in a direction opposite to the protruding direction of the terminals 12. The inclined portions 23 are slant at a predetermined angle to connect the die bonding pad 21 to the terminals 22.

As shown in Fig. 4, the first lead group 31 A includes four parallel leads 31 arranged between the two terminals 12. Each of the leads 31 includes a terminal 31 a, an inclined portion 31 b, and a wire bonding pad 31 c (see also Fig. 3). The terminal 31 a is positioned at the same height as the terminals 12, and serves, together with the terminals 12, 22, as a connecting terminal for incorporating the semiconductor device A1 into a circuit. As shown in Fig. 3, the wire bonding pad 31 c is positioned at the same height as the semiconductor element 41 but higher than the terminal 31 a. The inclined portion 31 b connects the terminal 31 a and the wire bonding pad 31 c to each other.

The second lead group 32A includes four parallel leads 32 arranged between the two terminals 22. Each of the leads 32 includes a terminal 32a, an inclined portion 32b, and a wire bonding pad 32c. The terminal 32a is positioned at the same height as the terminals 22, and serves, together with the terminals 12, 22, and 31 a, as a connecting terminal for incorporating the semiconductor device A1 into a circuit. As shown in Fig. 3, the wire bonding pad 32c is positioned at the same height as the semiconductor element 42 but higher than the terminal 32a. The inclined portion 32b connects the terminal 32a and the wire bonding pad 32c to each other.

The first semiconductor element 41 is bonded to the die bonding pad 11 and electrically connected to the wire bonding pads 31 c via the wire group 51. The second semiconductor element 42 is bonded to the die bonding pad 21 and electrically connected to the wire bonding pads 32c via the wire group 52. The wire bonding pads 31 c are positioned on a left side (as viewed in Fig. 4), and accordingly, the connecting portions 41 a of the semiconductor element 41 and the wire group 51 are also positioned to the left. On the other hand, since the wire bonding pads 32c are positioned on a right side, the connecting portions 42a of the semiconductor element 42 and the wire group 52 are also positioned to the right. In the illustrated embodiment, the first and the second semiconductor elements 41, 42 are identical in shape and size to each other, though the present invention is not limited to this. They may be different in shape or size or both.

As shown in Fig. 4, the connecting portions 41 a of the first semiconductor element 41 and the connecting portions 42a of the second semiconductor element 42 are arranged at noninterfering locations to each other. Thus, if any one of the connecting portions 41 a was moved horizontally to the right, it would not bump into any one of the connecting portions 42a, and just pass through between two adjacent connecting portions 42a. Likewise, if any one of the connecting portions 42a was moved horizontally to the left, it would not bump into any one of the connecting portions 41 a. With the above arrangement, the first and second wire groups 51, 52 are prevented from interfering with each other, even if the connecting portions 41 a are disposed very close to the connecting portions 42a.

In the illustrated embodiment, each of the wire groups 51, 52 consists of four wires, and each wire is connected to only one of the wire bonding pads 31 c, 32c. Of course, the present invention is not limited to the illustrated configuration. Each wire group 51, 52 may include a greater number of wires. More than one wire may be bonded to a single bonding pad 31 c or 32c.

The resin package 60 is made of e.g. epoxy resin for covering the die bonding pads 11-12 (except for their surfaces 11 a and 21 a), the wire bonding pads 31 c, 32c, the semiconductor elements 41, 42, and the wire groups 51, 52. As noted above, the resin package 60 permits the lower surface 11 a and the upper surface 21 a of the die bonding pads 11 and 21, respectively, to be exposed to the outside. Although in the illustrated embodiment, the resin package 60 entirely covers the inclined portions 23, 31 b, and 32b, the whole or part of each inclined portion may be exposed. Further, the resin package 60 may be composed of two separate parts, one for covering the first semiconductor element 41 and the other for covering the second semiconductor element 42.

The two main leads 10, 20 and the two leads 31, 32 are cut out of the same lead frame made of a metal with high electrical and thermal conductivity such as Cu and

Ni, for example. The wires of the groups 51, 52 may be made of Au, for example.

The functions of the semiconductor device A1 will be described below.

According to the above-described semiconductor device A1, two semiconductor elements can be provided within a small area (as viewed in plan) in which, conventionally, only one semiconductor element is arranged. Thus, the space necessary for mounting the semiconductor device A1 is much smaller than that for mounting two semiconductor devices each having a single semiconductor element. Further, the semiconductor device A1 can enjoy good heat dissipation. In use, a substrate, for example, is attached to the bottom surface of the resin package 60, while a heat sink is attached to the top surface of the resin package 60. In this manner, the lower surface 11 a of the die bonding pad 11 embedded in a lower portion of the package 60 is held in direct contact with the substrate, and the upper surface 21 a of the die bonding pad 21 embedded in an upper portion of the package 60 is held in direct contact with the heat sink. Accordingly, heat generated at the semiconductor elements 41, 42 in operation is dissipated efficiently to the outside. Still further, in the semiconductor device A1, the wire groups 51, 52 are prevented from interfering with each other as noted above referring to Fig. 4. Thus, the distance between the two semiconductor elements 41 and 42 can be very small without impairing the function of the device. Accordingly, the height of the semiconductor device A1 can be small.

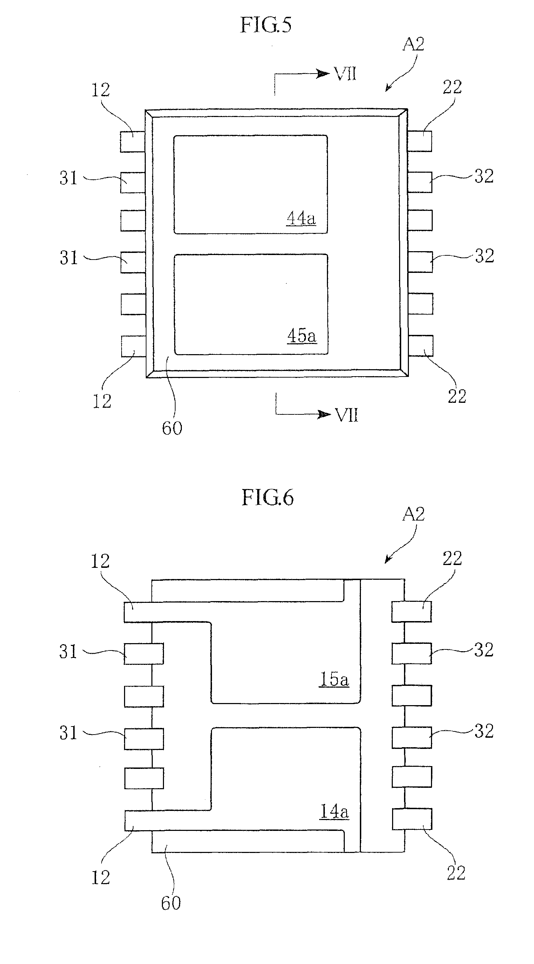

In the above-described embodiment, a single semiconductor element is bonded to each of the die bonding pads 11, 21. According to the present invention, however, more than one semiconductor element may be bonded to the bonding pads. For instance, two semiconductor elements may be bonded to the pad 11, and two other semiconductor elements may be bonded to the pad 21, so that a total of four semiconductor elements are incorporated in a single semiconductor device. In such an instance, the pads (supporting conductors) 11, 21 may be divided into two or more parts each carrying at least one semiconductor element. The numbers of the semiconductor elements mounted on the upper and lower pads may not be the same. Embodiments having such features will be described below with reference to Figs. 5-10. In these figures, the members identical or similar to those of the first embodiment are indicated by the same reference signs used in figures 1-4.

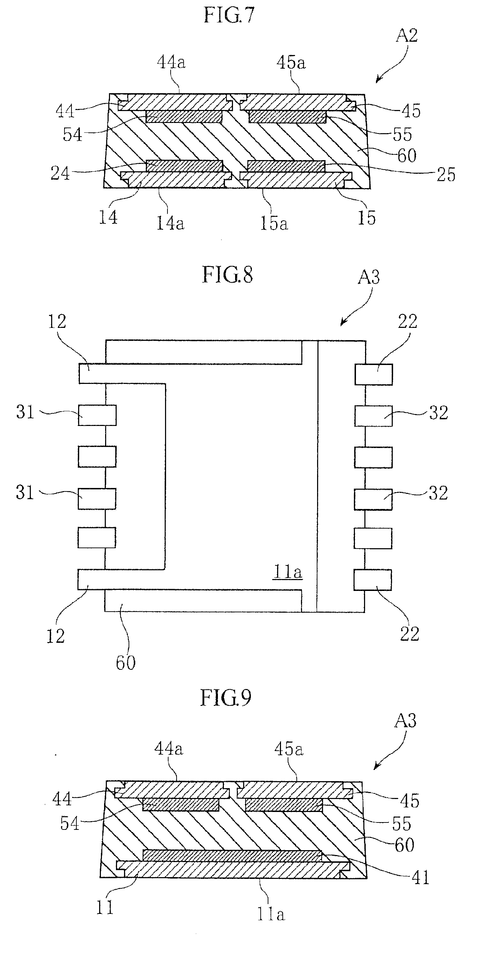

Figs. 5-7 show a semiconductor device according to a second embodiment of the present invention. The illustrated semiconductor device A2 is basically the same as or similar to the device A1 of the first embodiment except for the following features. Specifically, as seen from the figures, two lower die bonding pads 14, 15 and two upper die bonding pads 44, 45 are used in place of the first and the second die bonding pads 11, 21 of the first embodiment. Thus, in this embodiment, the first supporting conductor is comprised of the two lower pads 14 and 15, while the second supporting conductor is comprised of the two upper pads 44, 45. As shown in Fig. 7, each of the die bonding pads carries one of the semiconductor elements 24, 25, 54 and 55. The left-hand semiconductor elements 24 and 54 are vertically spaced from each other in a parallely facing manner. Likewise, the right-hand semiconductor elements 25 and 55 are vertically spaced from each other in a parallely facing manner.

As shown in Fig. 5, the upper surfaces 44a, 45a of the respective upper pads 44, 45 are exposed to the outside at the upper surface of the resin package 60. Though not shown in Fig. 5, the pad 44 is connected to one of the terminals 22, and the pad 45 to the other terminal 22, via inclined portions like the ones shown in Fig. 2 (at reference numeral 23). As shown in Fig. 6, the lower surfaces 14a, 15a of the respective lower pads 14, 15 are exposed to the outside at the bottom surface of the resin package 60. The pad 14 is connected to one of the terminals 12, and the pad 15 to the other terminal 12. According to the second embodiment, the upper semiconductor elements 54, 55 are arranged to face the lower semiconductor elements 24, 25, as shown in Fig. 7. Thus, the semiconductor device A2 can be made compact, even though a total of four semiconductor elements are incorporated in the single resin package 60.

Figs. 8 and 9 show a semiconductor device A3 according to a third embodiment of the present invention. The semiconductor device A3 is basically the same as or similar to the device A1 of the first embodiment except that two upper die bonding pads 44, 45 are used in place of the second die bonding pad 21 of the first embodiment, with one semiconductor element 54 or 55 bonded to each pad 44, 45. In this third embodiment, the first supporting conductor is comprised of the single pad 11, while the second supporting conductor is comprised of the two pads 44, 45. As in the second embodiment described above, the upper pads 44, 45 have their respective upper surfaces 44a, 45a exposed to the outside of the resin package 60 in the same manner as shown in Fig. 5. The single lower die bonding pad 11 carries one semiconductor element 41 and has its lower surface 11 a exposed to the outside of the resin package 60, as shown in Fig. 8. Each of the upper semiconductor elements 54, 55 is vertically spaced from the lower semiconductor element 41 in a parallely facing manner.

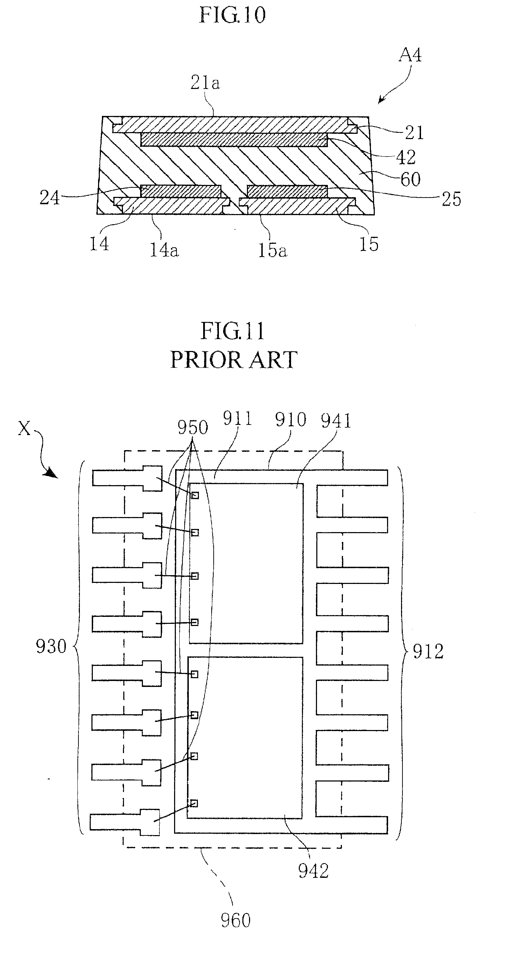

Fig. 10 is a sectional view showing a semiconductor device A4 according to a fourth embodiment of the present invention. The semiconductor device A4 is basically the same as or similar to the device A1 of the first embodiment except that two lower die bonding pads 14, 15 are used in place of the first die bonding pad 11 of the first embodiment, with one semiconductor element 24 or 25 bonded to each pad 14, 15. In this fourth embodiment, the first supporting conductor is comprised of the two lower pads 14 and 15, while the second supporting conductor is comprised of the single upper pad 21. As in the second embodiment described above, the lower pads 14, 15 have their respective lower surfaces 14a, 15a exposed to the outside of the resin package 60 in the same manner as shown in Fig. 6. The upper die bonding pad 21 carries one semiconductor element 42 and has its upper surface 21 a exposed to the outside of the resin package 60 in the same manner as shown in Fig. 1. The upper semiconductor element 42 is vertically spaced from each of the lower semiconductor elements 24, 25 in a parallely facing manner.

According to the present invention, the lower surface of a lower die bonding pad or the upper surface of an upper die bonding pad may not be exposed entirely, but only partially exposed. The number of the terminals 12 or 22 may be changed, and the number and arrangement of the leads 31, 32 may be changed. All of the leads 31, 32 may not be used for electrical connection.

## Claims

1. A semiconductor device comprising:
a resin package including a first surface and a second surface opposite to the first surface;
a first supporting conductor adjacent to the first surface and embedded in the resin package;
a second supporting conductor adjacent to the second surface and embedded in the resin package, the second supporting conductor being spaced apart from the first supporting conductor by a predetermined distance;
a first semiconductor element covered by the resin package and bonded to the first supporting conductor; and
a second semiconductor element covered by the resin package and bonded to the second supporting conductor, the second semiconductor element facing the first semiconductor element;
wherein at least part of the first supporting conductor is exposed at the first surface of the resin package, and at least part of the second supporting conductor is exposed at the second surface of the resin package.

2. The semiconductor device according to claim 1, wherein at least part of the first semiconductor element and at least part of the second semiconductor element are located between the first supporting conductor and the second supporting conductor.

3. The semiconductor device according to claim 1, wherein the predetermined distance is greater than a sum of a thickness of the first semiconductor element and a thickness of the second semiconductor element.

4. The semiconductor device according to claim 1, wherein the first supporting conductor comprises a plurality of die bonding pads, the first semiconductor element being mounted on one of the plurality of die bonding pads.

5. The semiconductor device according to claim 1, wherein the second supporting conductor comprises a plurality of die bonding pads, the second semiconductor element being mounted on one of the plurality of die bonding pads.

6. The semiconductor device according to claim 1, wherein the first supporting conductor comprises a plurality of first die bonding pads, and the second supporting conductor comprises a plurality of second die bonding pads, the first semiconductor element being mounted on one of the plurality of first die bonding pads, the second semiconductor element being mounted on one of the plurality of second die bonding pads.

7. The semiconductor device according to claim 1, further comprising a plurality of first leads connected to the first semiconductor element and a plurality of second leads connected to the second semiconductor element, wherein the plurality of first leads and the plurality of second leads protrude from the resin package in opposite directions.

8. The semiconductor device according to claim 7, further comprising a plurality of first wires and a plurality of second wires, wherein the plurality of first wires connect the plurality of first leads to the first semiconductor element, and the plurality of second wires connect the plurality of second leads to the second semiconductor element, the plurality of first wires being out of contact with the plurality of second wires.
